# EUROPEAN PATENT SPECIFICATION

(11) **EP 2 826 057 B1**
(45) Date of publication and mention of the grant of the patent: **24.01.2018**
(21) Application number: 12709309.4
(22) Date of filing: 12.03.2012
(51) Int. Cl.: H01J 37/34, H01J 37/32

(54) **MINI ROTATABLE SPUTTER DEVICES FOR SPUTTER DEPOSITION**
DREHBARE MINIZERSTÄUBERVORRICHTUNGEN FÜR ZERSTÄUBUNGSABSCHEIDUNGEN
MINI-DISPOSITIFS DE PULVÉRISATION CATHODIQUE ROTATIFS POUR DÉPOSITION PAR PULVÉRISATION CATHODIQUE

(43) Date of publication of application: 21.01.2015
(73) Proprietor: Applied Materials, Inc., Santa Clara, CA 95054 (US)
(72) Inventor: DEPPISCH, Thomas, 63743 Aschaffenburg (DE); SCHNAPPENBERGER, Frank, 55218 Ingelheim (DE); LOPP, Andreas, 63579 Freigericht (DE); FLOCK, Annemarie, 64850 Shaafheim (DE); GÖRISCH, Götz, 64297 Darmstadt (DE)
(74) Representative: Zimmermann & Partner Patentanwälte mbB
(86) International application number: PCT/EP2012/054261
(87) International publication number: WO 2013/135265

(56) References cited:
- WO-A1-2012/066079
- DE-A1- 19 610 253
- DE-C1- 10 145 201

## Description

### TECHNICAL FIELD OF THE INVENTION

Embodiments of the present invention relate to sputter devices in deposition chambers and to a method for depositing material in a deposition process. Embodiments of the present invention particularly relate to rotatable sputter devices, specifically to rotatable sputter devices in a sputter deposition chamber.

### BACKGROUND OF THE INVENTION

Several methods are known for depositing a material on a substrate. For instance, substrates may be coated by a physical vapor deposition (PVD) process, such as a sputter process. Typically, the process is performed in a process apparatus or process chamber, where the substrate to be coated is located or guided through. A deposition material is provided in the apparatus. In the case where a PVD process is performed, the deposition material is typically in the solid phase and a reaction gas may be added during the process. A plurality of materials may be used for deposition on a substrate; among the materials, ceramics can be used.

Coated materials may be used in several applications and in several technical fields. For instance, an application lies in the field of microelectronics, such as generating semiconductor devices. Also, substrates for displays are often coated by a PVD process. Further applications may include insulating panels, organic light emitting diode (OLED) panels, but also hard disks, CDs, DVDs and the like. Document DE 101 45 201 C1 describes an apparatus for coating substrates having a curved surface by magnetron sputter devices. Document DE 196 10 253 A1 refers to a sputter apparatus with rotatable electrodes.

Substrates are arranged in or guided through a deposition chamber for performing the coating process. For instance, a web to be coated may be guided through the deposition chamber by several guiding devices, such as coating drums. The sputter device provides a target made of the material to be deposited on the substrate. The substrate to be coated is guided past the sputter device so that the material released from the target reaches the substrate while passing the sputter device. Guiding the substrate on coating drums is very space efficient, however, due to the coating drum, the substrate to be coated faces the sputter device only for a short time period, which results in a low deposition rate of the material released from the target on the substrate to be coated. Thus, a large portion of the material to be deposited does not reach the substrate and is wasted in the deposition apparatus.

In view of the above, it is an object of the present invention to provide a deposition apparatus and a method for depositing material on a web that overcomes at least some of the problems in the art.

### SUMMARY OF THE INVENTION

In light of the above, a deposition apparatus according to independent claim 1, and a method for depositing deposition material according to independent claim 11, are provided. Further aspects, advantages, and features of the present invention are apparent from the dependent claims, the description and the accompanying drawings.

According to one embodiment, a deposition apparatus as defined in claim 1 is provided.

According to another embodiment, a method as defined in claim 11 is provided.

Embodiments are also directed at apparatuses for carrying out the disclosed methods and include apparatus parts for performing each described method step. These method steps may be performed by way of hardware components, a computer programmed by appropriate software, by any combination of the two or in any other manner. Furthermore, embodiments according to the invention are also directed at methods by which the described apparatus operates. It includes method steps for carrying out every function of the apparatus.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Fig. 1: shows a deposition apparatus as known in the art;
- Fig. 2: shows a schematic cross sectional view of a deposition apparatus according to embodiments described herein;
- Fig. 3: shows a schematic top view of a deposition apparatus according to embodiments described herein;
- Fig. 4: shows a schematic side view of a deposition apparatus according to embodiments described herein;
- Fig. 5: shows a schematic view of twin sputter devices of a deposition apparatus according to embodiments described herein;
- Fig. 6: shows a schematic view of twin sputter devices of a deposition apparatus according to embodiments described herein; and
- Fig. 7: shows a flow chart of a method for depositing material according to embodiments described herein.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations. The invention is defined by the claims.

Furthermore, in the following description, a "sputter device" is to be understood as a device including the deposition material or a component of the deposition material to be deposited on a substrate in form of a target. The target may be made from the material to be deposited or at least components of the material to be deposited. Further, a sputter device may be designed as a rotatable sputter device having a rotation axis. According to some embodiments, the sputter device may include a backing tube on which the target made of deposition material or a component of deposition material may be arranged. The sputter device may include a magnet arrangement for generating a magnetic field during operation of the sputter device. In the case, where a magnet arrangement is provided in the sputter device, the sputter device may be referred to as a sputter magnetron. Further, cooling channels may be provided within the sputter device in order to cool the sputter device or parts of the sputter device. According to some embodiments, the sputter device may be adapted to be connected to a sputter device support of a deposition apparatus or a deposition chamber, e.g. a flange may be provided at an end of the sputter device. According to some embodiments, the sputter device may be operated as a cathode or as an anode.

The term "twin sputter device" refers to a pair of sputter device. A first sputter device and a second sputter device may form a twin sputter device pair. For instance, both sputter devices of the twin sputter device pair may be simultaneously used in the same deposition process to coat the same substrate. Twin sputter devices may be used to coat the same section of a substrate at the same time. Further, twin sputter devices may be designed in a similar way that means the twin sputter devices may provide the same material as target, may substantially have the same size and substantially the same shape or the like. In some cases, the twin sputter devices are arranged adjacent to each other in a deposition apparatus. For instance, the twin sputter devices may be held by one or more sputter device supports in a deposition chamber so as to provide the material to be deposited on the substrate in a coating window. According to some embodiments, which can be combined with other embodiments described herein, the two sputter devices of a twin sputter device include the same material in form of a target.

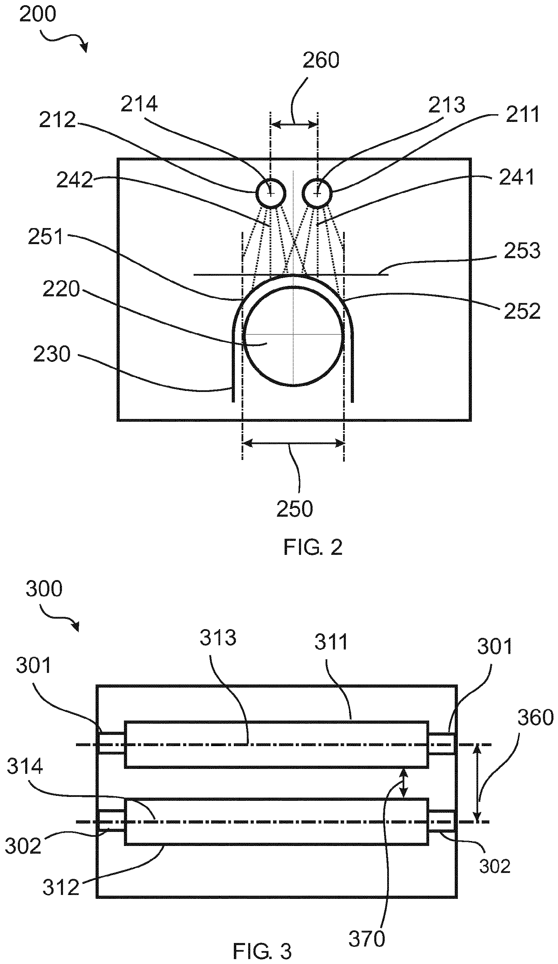

The term "coating window" may be understood as an area of a deposition apparatus, through which the material released from the sputter device reaches the substrate. In more detail, the material to be deposited is released from the target of the sputter device. The coating window is defined by a mask or a blocking portion for blocking some of the deposition material. The size of the coating window is defined in the substrate plane. Since the substrate is guided on a coating drum, the substrate plane is a plane substantially tangential to the substrate at a certain point. The point on the substrate in which the tangential plane to the substrate may be determined is a point on the substrate having the shortest distance to a sputter device. According to an example, the coating window may also be defined by a section of a coating drum, i.e. by the section of the coating drum facing the sputter devices. For instance, if a web to be coated is guided over a coating drum, there is a first position of the web on the drum projected to the substrate plane and a second position of the web on the drum projected to the substrate plane. The particles of the deposition material reach the substrate when the substrate is located between the first and the second position, i.e. in the coating window being measured in the substrate plane, as explained in detail below with respect to Fig. 2. In another example, the coating window may be defined by an angular section of the coating drum, which the substrate passes, such as an angular section including typically a range of about 10° to about 90°, more typically of about 10° and about 40°, and even more typically between about 10° and about 20°, such as 16°.

The term "deposition process" may generally refer to any process, by which material is released from the target of a sputter device and deposited on a substrate, such as a PVD process, a reactive sputter process, or the like. Further, the term "substantially" as used herein may mean that there may be a certain deviation from the characteristic denoted with "substantially." For instance, the term "substantially tangential" refers to a position which may have certain deviations from the exact tangential direction, such as a deviation of about 1% to about 10% from the exact tangential position.

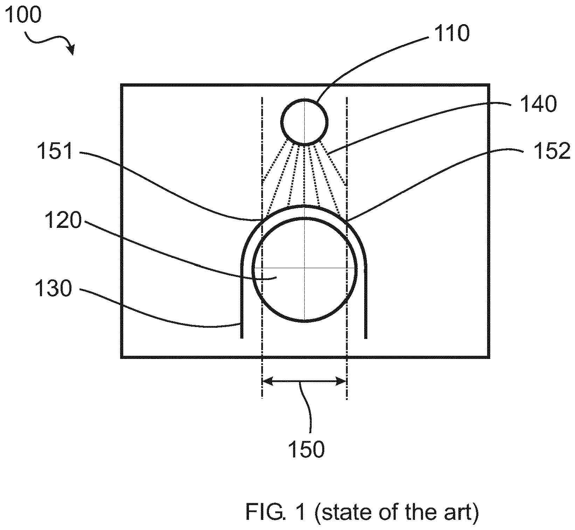

Fig. 1 shows a deposition apparatus as known in the art. The deposition apparatus 100 provides a rotatable sputter device 110 and a coating drum 120. A substrate to be coated, such as a web 130, is guided by the coating drum. During operation of the deposition apparatus, material to be deposited, i.e. deposition material, is released from the sputter device 110. Particles 140 spread from the sputter device and deposit on the web 130. Further, a coating window 150 can be seen in Fig. 1. The coating window ranges from a first position 151 of the coating drum 120 to a second position 152 of the coating drum 120. In the coating window, about 99% of the deposited material reaches the substrate to be coated.

However, sputter compartments, such as deposition apparatus of Fig. 1 in web coating processes have limited size, since the substrate is running over a round coating drum. Due to the desired small chamber size, the coating window provides a restricted size too. In the example of Fig. 1, the coating window has a size of about 220mm in the substrate plane. That means, in the above described deposition apparatus, the collection efficiency, i.e. the percentage of released material reaching the substrate is at about 30%. The rest of the material released from the sputter device is wasted. Widening the coating window to a size of about 400mm may increase the deposition efficiency, but reduces the number of cathodes in one deposition machine. Thus, the overall efficiency of the deposition machine having several coating apparatuses would decrease. Further, it is known to use two sputter devices for substrates being guided through a deposition chamber in a planar way, such as glass substrates. However, space restrictions prevent the use of two sputter devices in a web coating process.

Embodiments described herein provide a deposition apparatus, which increases the collection efficiency of the deposition apparatus without decreasing the overall efficiency of the deposition machine having several deposition apparatuses. According to embodiments described herein, a twin sputter device is used for a web coating process, in which the web to be coated is guided by a coating drum. Standard twin rotatable cathodes do not fit into typical sputter compartments of web coaters. To install known twin rotatable sputter devices, larger cathode compartments are required, which reduces the amount of different layers that can be deposited on one coating drum. This is not economical. Embodiments described herein provide a design of the twin sputter devices allowing using the twin sputter devices in a web coating apparatus. Thus, a deposition apparatus according to embodiments described herein provides small twin rotatable cathodes which fit well into sputter compartments of web coaters. In addition, the magnet system in the rotatable sputter devices may be adapted to further improve the deposition rate.

Fig. 2 shows a deposition apparatus according to embodiments described herein. Deposition apparatus 200 provides a coating drum 220, on which a substrate 230 to be coated is guided. The deposition material or a component of the deposition material is provided by a first sputter device 211 and a second sputter device 212 forming together a twin sputter device.

Known rotatable twin sputter device designs do not fit into the typical size of the compartments of a web coater. Therefore, only planar twin sputter devices were used before as rotatable twin sputter devices in web coaters were not yet available. Embodiments described herein thus describe a special design of rotatable twin sputter devices, which fit into standard sputter compartments for web coaters.

As can be seen in Fig. 2, the first sputter device 211 has a first axis 213, which may be the rotation axis of the first sputter device. The second sputter device 212 has a second axis 214, which may also be the rotation axis of the second sputter device. The sputter devices provide the deposition material i.e. the material to be deposited on the substrate to be coated in the form of a target. For reactive deposition processes, the material finally deposited on the substrate can additionally include compounds of a processing gas. Accordingly, the person skilled in the art will understand that a target consisting e.g. of silicon or doped silicon includes silicon as the deposition material, whereas examplarily oxygen can be added as a processing gas to finally deposit SiO2.

According to some embodiments exemplarily shown in FIG. 2, the substrate to be coated is a web 230 and the web is guided past the twin sputter devices 211 and 212 by a roller or a drum 220. Generally, the web to be coated may provide a flexible structure, such as a foil or a plastic web. The coating window 250 is limited by a first position 251 of the web 230 on the drum 220 projected to the substrate plane 253 and a second position 252 of the web 230 on the drum 220 projected to the substrate plane 253. Further, the coating window defines the area of the substrate on which material is deposited. As can be seen in Fig. 2, particles 241 of the deposition material released from the first sputter device 211 and particles 242 of the deposition material released from the second sputter device 212 reach the substrate 230 through the coating window 250. As can be seen in Fig. 2, the coating window 250 is measured in the substrate plane, which is a plane 253 substantially tangential to the substrate in one point.

The deposition apparatus 200, according to embodiments described herein, is adapted so as to provide a distance 260 of the first axis 213 of the first sputter device 211 to the second axis 214 of the second sputter device 212 of less than about 200mm. Typically, the distance 260 of the first axis 213 of the first sputter device 211 to the second axis 214 of the second sputter device 212 is between 150mm and 200mm, more typically between 160mm and 190mm, and even more typically between 170mm and 185mm, such as 180mm.

FIG. 3 shows a schematic top view of a deposition apparatus according to embodiments described herein. The deposition apparatus 300 may be a deposition apparatus as described with respect to FIG. 2. In FIG. 3, the sputter device support holding the twin sputter devices can be seen. In particular, a first sputter device support 301 holds the first sputter device 311 and a second sputter device support 302 holds the second sputter device 312. According to some embodiments, the first sputter device support 301 and the second sputter device support 302 may be adapted to hold the first sputter device 311 and the second sputter device 312 in a defined distance to each other. For instance, the first sputter device support 301 and the second sputter device support 302 may be interconnected to each other in order to provide the desired distance between the sputter devices. According to other embodiments, the sputter device support of the deposition apparatus may be one sputter device support being divided into two sections, namely a section for the first sputter device (such as the first sputter device support) and a section for the second sputter device (such as the second sputter device support). Generally, the sputter device support may have a mechanism (not shown) which allows for holding and rotating the sputter devices. For instance, the sputter device supports may provide bearings, which allow for a rotation of the sputter devices, but hold the sputter devices at the same time in a defined position with respect to the longitudinal and radial direction of the sputter devices.

According to some embodiments, the sputter device support defines the axes of the first sputter device and the second sputter device. For instance, by holding the sputter devices and allowing at the same time a rotation of the sputter devices, the sputter device support may define the axis of rotation of the first and the second sputter device. Further, sputter device support provides a defined distance between the sputter devices. In FIG. 3, the distance 360 between the first axis 313 of the first sputter device 311 and the second axis 314 of the second sputter device 312 (being defined by the sputter device supports 301 and 302) is less than about 200mm, typically between 150mm and 200mm, more typically between 160mm and 190mm, and even more typically between 170mm and 185mm, such as 180mm.

According to some embodiments, the outer diameter of the first sputter device and the second sputter device may typically be in a range of about 90mm to about 120mm, more typically between about 95mm and about 115mm, and even more typically between about 100mm and about 110mm, such as for example 105mm. Generally, the outer diameter of the first and second sputter device may be determined before any sputtering action takes place. Further, the sputter device supports 301 and 302 are adapted so that a distance 370, denoting a distance between the outer surfaces of the sputter devices before the deposition process, as shown in FIG. 3, is typically in the range between about 50mm and about 100mm, more typically between about 60mm and about 90mm, and even more typically between about 70mm and about 80mm, such as 75mm.

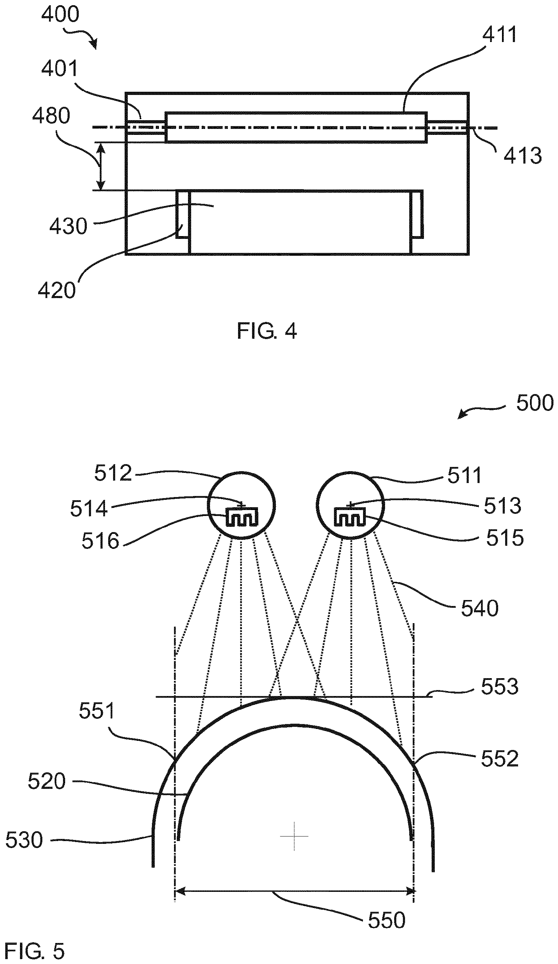

In FIG. 4, a schematic side view of a deposition apparatus can be seen. The deposition apparatus 400 may be a deposition apparatus as described with respect to FIGs. 2 or 3. The side view of FIG. 4 shows a first sputter device 411 of twin sputter devices in a deposition chamber 400. The sputter device support 401 defines the axis 413 of the sputter device 411. Further, a coating drum 420 can be seen, over which the substrate 430 may be guided. In the embodiment of FIG. 4, a distance 480 is shown, denoting the shortest distance from the outer surface of the sputter device 411 and the web 430 to be coated. The shortest distance between the web and the surface of the sputter device may typically be between 50mm and 200mm, more typically between 70mm and 190mm, and even more typically between about 80mm and about 180mm. In one embodiment, the shortest distance between the surface of a sputter device and a surface to be coated is about 100mm.

In the figures, the sputter devices are oriented above the substrate. However, it is to be understood that this is a mere example and that the orientation of the sputter devices and the substrate may be arranged in another way, such as sputter devices being arranged next to the substrate, or substrates being guided above the sputter devices.

Fig. 5 shows an arrangement 500 of twin sputter devices and a coating drum with a web, as may be used in the deposition apparatus according to embodiments of the invention. A first sputter device 511 and a second sputter device 512 are provided being arranged at a first axis 513 for the first sputter device 511 and a second axis 514 for the second sputter device 513. The twin sputter devices 511 and 512 may include a target being made of the material to be deposited or a component of the material to be deposited and are adapted to provide the deposition material for the substrate 530 through the coating window 550. The substrate 530 is guided by a coating drum 520. The coating window 550 is defined by the area through which particles 540 released from the twin sputter devices reach the substrate. The curvature of the coating drum 520 means that only a small section of the substrate 530 is exposed to the target material particles 540. The small section of the substrate may be limited by a first position 551 of the web 530 on the coating drum 520 projected to the substrate plane 553 and a second position 552 of the web 530 on the coating drum 530 projected to the substrate plane 553. The first position 551 and the second position 552 also denote the beginning and the end of the coating window 550. The size of the coating window 550 is measured in a substrate plane, such as plane 553, which is substantially tangential to the substrate on a coating drum 520 in at least one point. The point, in which the substrate plane 553 substantially tangential to the substrate is formed, is a point of the substrate having the shortest distance to at least one of the sputter devices.

Further, according to some embodiments, a first magnet arrangement 515 is located in the first sputter device 511 and a second magnet arrangement 516 is located in the second sputter device 512. The first magnet arrangement and the second magnet arrangement each generate a magnetic field. The magnetic fields generated by the magnet arrangements 515 and 516 generally help to increase the deposition efficiency. Further, the deposition rate may be positively influenced by using magnet arrangements in the sputter devices.

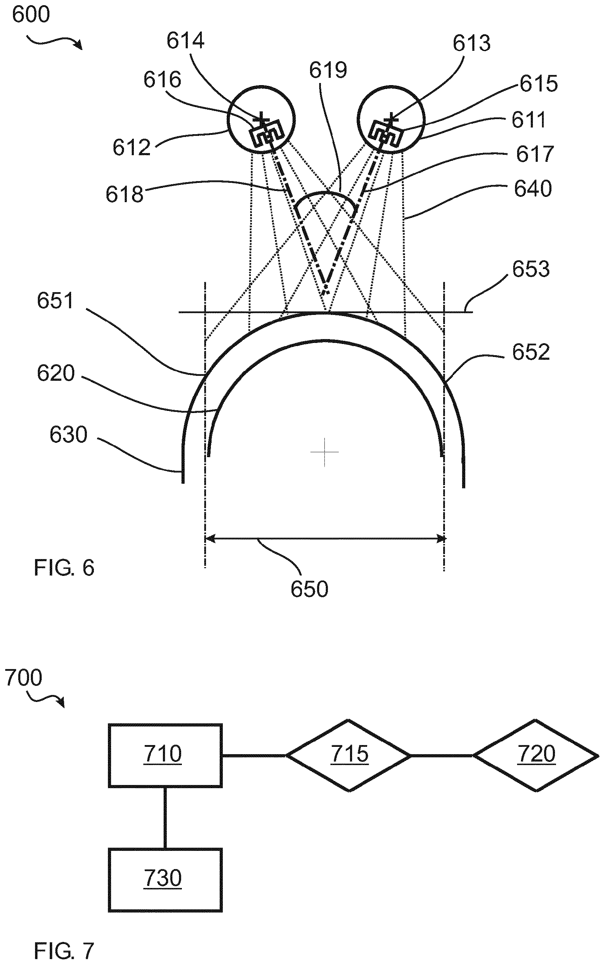

In FIG. 6, an embodiment of an arrangement 600 is shown including a twin sputter device, a coating drum and a substrate to be coated. The arrangement 600 may for instance be used in deposition apparatuses as described above with respect to FIGs. 2 to 4. The arrangement 600 includes a first sputter device 611, a second sputter device 612, a coating drum 620, and a substrate 630 to be coated. The substrate 630 to be coated is guided on the coating drum 620 past the sputter devices 611 and 612, and thus passes the coating window 650. The coating window 650 is limited by a first position 651 of the substrate 620 on the drum 630 projected to the substrate plane 653 and a second position 652 of the substrate 620 on the drum 630 projected to the substrate plane 653. Through the coating window 650, the particles 640 released from the twin sputter devices reach the substrate 620.

In the embodiment shown in FIG. 6, the first sputter device 611 is equipped with a first magnet arrangement 515 and the second sputter device 512 is equipped with a second magnet arrangement 516. The magnet arrangements 615 and 616 may be magnet yokes generating each a magnetic field to improve the deposition efficiency. According to some embodiments, the magnet arrangements may be tilted towards each other. This is shown in FIG. 6 by the magnet arrangements 515 and 516. According to some embodiments, the magnet arrangements may be tilted towards each other by arranging the first sputter device, the second sputter device, the first magnet arrangement and/or the second magnet arrangement in a respective way.

The magnet arrangements being arranged in a tilted way towards each other means, in this context, that the magnetic fields generated by the magnet arrangements are directed towards each other. For instance, a radial axis going from the rotation axis of the sputter device to the magnet arrangement or substantially the center of the magnet arrangement may form an angle to a respective axis of the other sputter device. The radial axes of the first sputter device 611 and the second sputter device 612 can be seen in FIG. 6. The first radial axis 617 extends from the first rotational axis 613 of the first sputter device 611 to the center of the first magnet arrangement 615. The second radial axis 618 extends from the second rotational axis 614 of the second sputter device 612 to the center of the second magnet arrangement 616. Between the radial axes 617 and 618, an angle 619 is shown indicating the tilt of the magnet arrangements towards each other.. According to some embodiments, the angle between the magnet arrangements, such as the angle 619 in FIG. 6, may typically lie in the range of about 5° to about 50°, more typically between about 10° and about 40°, and even more typically between about 10° and about 30°.

According to some embodiments, the above described sputter devices may be used to deposit isolating material on a web. For instance, the sputter device may provide target material such as silicon, titanium, aluminum. Together with a gas inlet, materials such as silicon oxide, silicon nitride, titanium oxides, aluminum oxide, and the like, may be deposited on the substrate, e.g. by reactive sputtering processes. Further, the deposition apparatuses as described above may be used for a reactive sputter process, such as reactive sputtering of SiO₂. Thus, according to some embodiments, which may be combined with other embodiments described herein, the deposition apparatus may be provided with further equipment, such as vacuum pumps, gas inlets for process gases (such as oxygen or nitrogen), heating means, cooling means, drives, and the like.

According to some embodiments, the deposition apparatuses and the arrangements described above may be used in a process, where two metallic sputter devices are operated with middle frequency (MF), such as with a frequency range of between about 10kHz to about 50kHz. In one embodiment, the deposition apparatus and/or the sputter device supports of the deposition apparatuses may be adapted for using one of the sputter devices as an anode, and the respective other one as a cathode. Generally, the deposition apparatus is adapted so that the operation of the sputter devices as anode and cathode may be alternated. That means that the sputter device being formerly used as anode may be used as a cathode, and the sputter device being formerly used as a cathode may be operated as an anode.

In one embodiment, the deposition apparatus as described above may provide one sputter device for one sputter device support. This means that only one rotatable sputter device is provided in one sputter device support. For instance, one first sputter device is arranged in the first sputter device support and one second sputter device is arranged in the second sputter device support. According to some embodiments, a pair of twin sputter devices, i.e. one first sputter device and one second sputter device, is provided for one coating window. A deposition apparatus generally may have several coating windows and only one first and only one second sputter device may be used for each coating window, respectively. The coating window may be understood as being defined as a section through which the material to be deposited reaches the substrate. Thereby, the substrate passes the first and the second sputter device by passing the coating window.

FIG. 7 shows a flow chart of a method for depositing deposition material on a web according to embodiments described herein. According to some embodiments, the method may be used for operating a deposition apparatus as described above with respect to FIGs. 2 to 4, or an arrangement as shown in FIGs. 5 and 6. The method may include, in block 710, guiding a web on a coating drum past a first sputter device and a second sputter device. According to some embodiments, the sputter devices may be sputter devices as described above, which provide the material to be deposited on a substrate, such as the web. For instance, the web according to embodiments described herein passes twin sputter devices, as indicated by block 715. The sputter devices may be rotatable sputter devices, each having an axis of rotation. According to some embodiments, the first rotatable sputter device and the second rotatable sputter device are arranged so that the distance between the rotation axis of the first sputter device and the rotation axis of the second sputter device is less than about 200mm, which is denoted as block 720 in FIG. 7. In some embodiments, the distance between the rotation axis of the first sputter device and the rotation axis of the second sputter device is between 150mm and 200mm, more typically between 160mm and 190mm, and even more typically between 170mm and 185mm, such as 180mm.

Further, the method according to embodiments described herein includes in block 730 coating the web with deposition material from the first and the second sputter device. Generally, the material deposited on the web is released from the sputter device and is deposited on the web in one coating window. The coating window may be defined as a section in the substrate plane, through which the deposition material passes for reaching the substrate. When the web passes the coating window, the web is exposed to the particles released from the sputter devices. According to some embodiments, the coating takes place while the web is guided on the coating drum past the first rotatable sputter device and the second rotatable sputter device.

According to some embodiments, the coating window may have a size of typically between about 200mm and 230mm, such as 220mm in the substrate plane. The width of the coating window is defined by a first position and a second position on the coating drum being projected to the substrate plane and limiting the coating window. For instance, the width of the coating window can be seen in Figs. 2 to 6 as coating window 250, 350, 450, 550, and 650.

The method according to embodiments described herein may further include using one of the first sputter device and the second sputter device as an anode and the respective other one of the first sputter device and the second sputter device as a cathode. According to some embodiments described herein, which may be combined with other embodiments described herein, the deposition apparatus, and particularly, the sputter device supports of a deposition apparatus, may by adapted to provide the respective function, i.e. allowing to use one sputter device as an anode and the other sputter device as a cathode in an alternating way.

In one embodiment, the method of depositing material on a web further includes generating a first magnetic field by a first magnet arrangement in the first sputter device and generating a second magnetic field by a second magnet arrangement in the second sputter device. Such an arrangement, as described above, is exemplarily shown in FIG. 5. Further, according to some embodiments, the magnet arrangements may be arranged in a tilted way towards each other by arranging the first sputter device, the second sputter device, the first magnet arrangement and/or the second magnet arrangement in a respective way. Such an arrangement is shown in FIG. 6, where the radial axes 617 and 618, together with the angel 619, indicate the tilted arrangement.

Using a deposition apparatus and a method for depositing deposition material, according to the embodiments described herein, allows for high sputter device utilization (to about 80%) and redeposition free erosion profiles. This saves material costs and makes the process more efficient. In addition, for sputter up applications, as used in web coaters, the quality of the sputter process can be improved, as particles cannot fall onto the sputter devices, which can cause arcing and limits therefore layer properties. Further, embodiments described herein may be applied for systems which have limited size for sputter cathodes, and which could not use twin rotatable sputter devices due to space restrictions.

In one aspect, a deposition apparatus for depositing deposition material on a web is provided. The deposition apparatus may include a first sputter device support defining a first axis for a first rotatable sputter device, a second sputter device support defining a second axis for a second rotatable sputter device, and a coating window. According to some embodiments, the first sputter device support and the second sputter device support are adapted for supporting the first rotatable sputter device and the second rotatable sputter device to provide the deposition material to be deposited on the web over a coating drum. The distance between the first axis and the second axis is smaller than about 200 mm. Further, according to some embodiments, which can be combined with other embodiments described herein, the deposition apparatus may be adapted to use one rotatable sputter device of the first rotatable sputter device and the second rotatable sputter device as an anode and the respective other rotatable sputter device of the first rotatable sputter device and the second rotatable sputter device as a cathode. In one embodiment, the deposition apparatus may further include a first rotatable sputter device and a second rotatable sputter device. According to some embodiments, which can be combined with other embodiments described herein, a first magnet arrangement for generating a first magnetic field may be arranged in the first rotatable sputter device, and a second magnet arrangement for generating a second magnetic field may be arranged in the second rotatable sputter device. The first magnet arrangement and the second magnet arrangement may further be adapted to increase the deposition of deposition material in the coating window. In one embodiment, the first rotatable sputter device and the second rotatable sputter device may be arranged so that the first magnet arrangement and the second magnet arrangement are arranged in a tilted way towards each other. According to some embodiments, which can be combined with other embodiments described herein, at least one of the first sputter device support and the second sputter device support may be adapted to hold a rotatable sputter device having an outer diameter between about 100 mm and about 120 mm, particularly about 105 mm. Further, in one embodiment, the first sputter device support and the second sputter device support may be adapted to provide only one first rotatable sputter device in the first sputter device support, and only one second rotatable sputter device in the second sputter device support for one coating window. According to a further embodiment, the first sputter device support is adapted to hold the first sputter device and the second sputter device support is adapted to hold the second sputter device and the first sputter device and the second sputter device are twin sputter devices. The coating window provides a width of between about 200mm to about 250mm, particularly about 220mm. In one embodiment, which can be combined with other embodiments described herein, the material to be deposited may be an isolating material. For instance, the material to be deposited may be selected from the group of silicon oxide, silicon nitride, titanium oxide and aluminum oxide.

In a further aspect, a method for depositing deposition material on a web is provided. The method includes guiding the web on a coating drum past a first sputter device and a second sputter device, wherein the first sputter device and the second sputter device are rotatable twin sputter devices and provide the deposition material or a component of the deposition material. Further, the first rotatable sputter device and the second rotatable sputter device are arranged so that the distance between a rotation axis of the first sputter device and a rotation axis of the second sputter device is less than about 200mm. The method further includes coating the web with deposition material in one coating window while guiding the web past the first rotatable sputter device and the second rotatable sputter device. According to some embodiments, coating the web includes coating the web in a coating window of about 220mm. In one embodiment, which may be combined with other embodiments described herein, the method further includes using one of the first sputter device and the second sputter device as an anode and the respective other one of the first sputter device and the second sputter device as a cathode. According to some embodiments, the method for depositing material may further include generating a first magnetic field by a first magnet arrangement in the first sputter device and generating a second magnetic field by a second magnet arrangement in the second sputter device. Generally, at least one of the first sputter device, the second sputter device, the first magnet arrangement and the second magnet arrangement may be arranged so that the first magnet arrangement and the second magnet arrangement are arranged in a tilted way towards each other.

While the foregoing is directed to embodiments of the invention, other and further embodiments of the invention may be devised without departing from the basic scope thereof, and the scope thereof is determined by the claims that follow.

## Claims

1. Deposition apparatus (200; 300) for depositing deposition material on a web (230; 430; 530), comprising a first sputter device support (301; 401) defining a first axis (213; 313; 513) for a first rotatable sputter device (211; 311; 511), a second sputter device support (302) defining a second axis (214; 314; 514) for a second rotatable sputter device (212; 312; 512), a coating drum (220; 420; 520) for guiding the web to be coated and a coating window (250; 350; 550),
wherein the coating window is defined by a mask or a blocking portion for blocking some of the deposition material;
wherein the first axis (213; 313; 513), the second axis (214; 314; 514) and a rotation axis of the coating drum are oriented in a first direction;
wherein the first sputter device support (301; 401) and the second sputter device support (302) are adapted to support the first rotatable sputter device (211; 311; 511) and the second rotatable sputter device (212; 312; 512) respectively such as to provide at least a component of the deposition material to be deposited on the web (230; 430; 530) guided over the coating drum (220; 420; 520), and wherein the first sputter device support and the second sputter device support are adapted to provide only one first rotatable sputter device in the first sputter device support, and only one second rotatable sputter device in the second sputter device support for one coating window (250; 350; 550);
and wherein the distance (260; 360) between the first axis (213; 313; 513) and the second axis (214; 314; 514) is smaller than about 200mm and wherein the coating window (250; 350; 550) provides a width of between about 200mm to about 250mm, the width of the coating window being defined by a first position (251; 551) and a second position (252; 552) of the web (230; 430; 530) on the coating drum (220; 420; 520) projected to a plane (253; 553) substantially tangential to the web (230; 430; 530) at a point on the web having the shortest distance to at least one of the sputter devices.

2. The deposition apparatus according to claim 1, wherein the deposition apparatus (200; 300) is adapted to use one rotatable sputter device of the first rotatable sputter device (211; 311; 511) and the second rotatable sputter device (212; 312; 512) as an anode, and the respective other rotatable sputter device of the first rotatable sputter device (211; 311; 511) and the second rotatable sputter device (212; 312; 512) as a cathode.

3. The deposition apparatus according to any of claims 1 to 2, further comprising a first rotatable sputter device (211; 311; 511) and a second rotatable sputter device (212; 312; 512).

4. The deposition apparatus according to claim 3, wherein a first magnet arrangement (515) for generating a first magnetic field is arranged in the first rotatable sputter device (211; 311; 511) and a second magnet arrangement (516) for generating a second magnetic field is arranged in the second rotatable sputter device (212; 312; 512), wherein the first magnet arrangement and the second magnet arrangement are adapted to increase the deposition of deposition material in the coating window (250; 350; 550).

5. The deposition apparatus according to claim 4, wherein the first rotatable sputter device (211; 311; 511) and the second rotatable sputter device (212; 312; 512) are arranged so that the first magnet arrangement (515) and the second magnet arrangement (516) are arranged in a tilted way towards each other.

6. The deposition apparatus according to any of claims 1 to 5, wherein at least one of the first sputter device support (301; 401) and the second sputter device support (302) is adapted to hold a rotatable sputter device having an outer diameter between about 100 mm and about 120 mm, particularly about 105 mm.

7. The deposition apparatus according to any of claims 1 to 6, wherein the first sputter device support is adapted to hold the first sputter device (211; 311; 511) and the second sputter device support is adapted to hold the second sputter device (212; 312; 512) and wherein the first sputter device and the second sputter device are twin sputter devices.

8. The deposition apparatus according to any of claims 1 to 7, wherein the coating window (250; 350; 550) provides a width of about 220mm.

9. The deposition apparatus according to any of claims 1 to 8, wherein the material to be deposited is an isolating material.

10. The deposition apparatus according to any of claims 1 to 9, wherein the material to be deposited is a material selected from the group of silicon oxide, silicon nitride, titanium oxide and aluminum oxide.

11. Method for depositing deposition material on a web (230; 430; 530) using the deposition apparatus of claim 1, comprising:
guiding the web on the coating drum (220; 420; 520) past a first sputter device (211; 311; 511) having the first rotation axis and a second sputter device (212; 312; 512) having the second rotation axis, wherein the first sputter device and the second sputter device are rotatable twin sputter devices provided for the coating window (250; 350; 550) and wherein the first sputter device (211; 311; 511) and the second sputter device (212; 312; 512) provide at least a component of the deposition material, and
coating the web (230; 430; 530) with deposition material in the coating window (250; 350;
550) while guiding the web over the coating drum (220; 420; 520).

12. The method according to claim 11, wherein coating the web (230; 430; 530) comprises coating the web in a coating window (250; 350; 550) of about 220mm.

13. The method according to any of claims 11 to 12, further comprising using one of the first sputter device (211; 311; 511) and the second sputter device (211; 311; 511) as an anode and the respective other one of the first sputter device and the second sputter device as a cathode.

14. The method according to any of claims 11 to 13, further comprising generating a first magnetic field by a first magnet arrangement (515) in the first sputter device (211; 311; 511) and generating a second magnetic field by a second magnet arrangement (516) in the second sputter device (212; 312; 512), wherein at least one of the first sputter device (211; 311; 511), the second sputter device (212; 312; 512), the first magnet arrangement (515) and the second magnet arrangement (516) are arranged so that the first magnet arrangement and the second magnet arrangement are arranged in a tilted way towards each other.

## Patentansprüche

1. Abscheidevorrichtung (200; 300) zum Abscheiden von Abscheidematerial auf ein Gewebe (230; 430; 530), mit einer ersten Sputterunterstützungseinrichtung (301; 401), welche eine erste Achse (213; 313; 513) für eine erste drehbare Sputtereinrichtung (211; 311; 511) definiert, einer zweiten Sputterunterstützungseinrichtung (302), welche eine zweite Achse (214; 314; 514) für eine zweite drehbare Sputtereinrichtung (212;312; 512) definiert, einer Beschichtungstrommel (220; 420;520) zum Führen des zu beschichtenden Gewebes und einem Beschichtungsfenster (250; 350; 550),
wobei das Beschichtungsfenster durch eine Abdeckung oder ein Abschirmungsteil zum Abschirmen eines Teils des Abscheidematerials definiert ist;
wobei die erste Achse (213; 313; 513), die zweite Achse (214; 314; 514) und die Rotationsachse der Beschichtungstrommel in einer ersten Richtung ausgerichtet sind;
wobei die erste Sputterunterstützungseinrichtung (301; 401) und die zweite Sputterunterstützungseinrichtung (302) ausgebildet sind, die erste drehbare Sputtereinrichtung (211; 311; 511) und die entsprechende zweite drehbare Sputtereinrichtung (212; 312; 512) zu tragen, um zumindest eine Komponente des auf das Gewebe (230; 430; 530) zu beschichtende Abscheidungsmaterials, welches über die Beschichtungstrommel (220; 420; 520) geführt wird, bereitzustellen, und wobei die erste Sputterunterstützungseinrichtung und die zweite Sputterunterstützungseinrichtung ausgebildet sind, nur eine erste drehbare Sputtereinrichtung in einer ersten Sputterunterstützungseinrichtung, und nur eine zweite drehbare Sputtereinrichtung in einer zweiten Sputterunterstützungseinrichtung für ein Beschichtungsfenster (250; 350; 550) bereitzustellen;
und wobei der Abstand (260; 360) zwischen der ersten Achse (213; 313; 513) und der zweiten Achse (214; 314; 514) kleiner als ungefähr 200 mm ist und wobei das Beschichtungsfenster (250; 350; 550) eine Breite zwischen ungefähr 200 mm bis 250 mm vorsieht, wobei die Breite des Beschichtungsfensters durch eine erste Position (251; 551) und eine zweite Position (252; 552) des Gewebes (230; 430; 530) auf der Beschichtungstrommel (220; 420; 520), welche auf einer im Wesentlichen tangential zu dem Gewebe (230; 430; 530) projizierten Ebene (253; 553) an einem Punkt auf dem Gewebe mit dem kürzesten Abstand zu mindestens einer der Sputtereinrichtungen definiert ist.

2. Die Abscheidevorrichtung nach Anspruch 1, wobei die Abscheidevorrichtung (200; 300) ausgebildet ist, eine erste drehbare Sputtereinrichtung der ersten drehbaren Sputtereinrichtung (211; 311; 511) und der zweiten drehbaren Sputtereinrichtung (212; 312; 512) als eine Anode, und die jeweils andere drehbare Sputtereinrichtung der ersten drehbaren Sputtereinrichtung (211; 311; 511) und der zweiten drehbaren Sputtereinrichtung (212; 312; 512) als eine Kathode zu verwenden.

3. Die Abscheidevorrichtung nach einem der Ansprüche 1 oder 2, ferner mit einer ersten drehbaren Sputtereinrichtung (211; 311; 511) und mit einer zweiten drehbaren Sputtereinrichtung (212; 312; 512).

4. Die Abscheidevorrichtung nach Anspruch 3, wobei eine erste Magnetanordnung (515) zur Erzeugung eines ersten magnetischen Feldes in der ersten drehbaren Sputtereinrichtung (211; 311; 511) angeordnet ist und eine zweite Magnetanordnung (516) zur Erzeugung eines zweiten magnetischen Feldes in der zweiten drehbaren Sputtereinrichtung (212; 312; 512) angeordnet ist, wobei die erste Magnetanordnung und die zweite Magnetanordnung ausgebildet sind, die Abscheidung des Abscheidungsmaterials in dem Beschichtungsfenster (250; 350; 550) zu erhöhen.

5. Die Abscheidevorrichtung nach Anspruch 4, wobei die erste drehbare Sputtereinrichtung (211; 311; 511) und die zweite drehbare Sputtereinrichtung (212; 312; 512) so angeordnet sind, dass die erste Magnetanordnung (515) und die zweite Magnetanordnung (516) zueinander geneigt angeordnet sind.

6. Die Abscheidevorrichtung nach einem der Ansprüche 1 bis 5, wobei die erste Sputterunterstützungseinrichtung (301; 401) und/oder die zweite Sputterunterstützungseinrichtung (302) ausgebildet ist, eine drehbare Sputtereinrichtung mit einem äußeren Durchmesser zwischen ungefähr 100 mm und ungefähr 120 mm, insbesondere ungefähr 105 mm, zu halten.

7. Die Abscheidevorrichtung nach einem der Ansprüche 1 bis 6, wobei die erste Sputterunterstützungseinrichtung ausgebildet ist, die erste Sputtereinrichtung (211; 311; 511) zu halten, und die zweite Sputterunterstützungseinrichtung ausgebildet ist, die zweite Sputtereinrichtung (212; 312; 512) zu halten, und wobei die erste Sputtereinrichtung und die zweite Sputtereinrichtung Zwillings-Sputtereinrichtungen sind.

8. Die Abscheidevorrichtung nach einem der Ansprüche 1 bis 7, wobei das Beschichtungsfenster (250; 350; 550) eine Breite von ungefähr 220 mm aufweist.

9. Die Abscheidevorrichtung nach einem der Ansprüche 1 bis 8, wobei das abzuscheidende Material ein isolierendes Material ist.

10. Die Abscheidevorrichtung nach einem der Ansprüche 1 bis 9, wobei das abzuscheidende Material eine Material ist, welches aus der Gruppe von Siliziumoxid. Siliziumnitride, Titanoxide und Aluminiumoxid ausgewählt wird.

11. Verfahren zum Abscheiden von Material auf ein Gewebe (230; 430; 530) unter Verwendung einer Abscheidevorrichtung nach Anspruch 1, aufweisend:
Führen des Gewebes auf der Beschichtungstrommel (220; 420; 520) nach einer ersten Sputtereinrichtung (211; 311; 511) mit der ersten Rotationsachse und nach einer zweiten Sputtereinrichtung (212; 312; 512) mit der zweiten Rotationsachse, wobei die erste Sputtereinrichtung und die zweite Sputtereinrichtung drehbare Zwillings-Sputtereinrichtungen sind, welche für das Beschichtungsfenster (250; 350; 550) bereitgestellt sind und wobei die erste drehbare Sputtereinrichtung (211; 311; 511) und die zweite drehbare Sputtereinrichtung (212; 312; 512) zumindest eine Komponente des Abscheidematerials bereitstellen, und
Beschichten des Gewebes (230; 430; 530) mit Abscheidematerial in dem Beschichtungsfenster (250; 450; 550) während das Gewebe über die Beschichtungstrommel (220; 420; 520) geführt wird.

12. Das Verfahren nach Anspruch 11, wobei das Beschichten des Gewebes (230; 430; 530) das Beschichten des Gewebes in einem Beschichtungsfenster (250; 350; 550) von ungefähr 220 mm umfasst.

13. Das Verfahren nach einem der Ansprüche 11 oder 12, welches ferner die Benutzung der ersten Sputtereinrichtung (211; 311; 511) oder der zweiten Sputtereinrichtung (212; 312; 512) als Anode und der jeweils anderen der ersten Sputtereinrichtung und der zweiten Sputtereinrichtung als Kathode umfasst.

14. Das Verfahren nach einem der Ansprüche 11 bis 13, welches ferner das Erzeugen eines ersten magnetischen Feldes durch eine erste Magnetanordnung (515) in der ersten Sputtereinrichtung (211; 311; 511) und das Erzeugen eines zweiten magnetischen Feldes durch eine zweite Magnetanordnung (516) in der zweiten Sputtereinrichtung (212; 312; 512) umfasst, wobei die erste Sputtereinrichtung (211; 311; 511) und die zweite Sputtereinrichtung (212; 312; 512), die erste Magnetanordnung (515) und/oder die zweite Magnetanordnung (516) so angeordnet werden, dass die erste Magnetanordnung und die zweite Magnetanordnung zueinander geneigt angeordnet sind.

## Revendications

1. Appareil de déposition (200 ; 300) pour déposer un matériau de dépôt sur une bande (230 ; 430 ; 530), comprenant un premier support de dispositif de pulvérisation cathodique (301 ; 401) définissant un premier axe (213 ; 313 ; 513) pour un premier dispositif de pulvérisation cathodique rotatif (211 : 311 ; 511), un second support de dispositif de pulvérisation cathodique (302) définissant un second axe (214 ; 314 ; 514) pour un second dispositif de pulvérisation cathodique rotatif (212 ; 312 ; 512), un tambour de revêtement (220 ; 420 ; 520) pour guider la bande afin d'être recouverte et une fenêtre de revêtement (250 ; 350 ; 550),
dans lequel la fenêtre de revêtement est définie par un masque ou une portion de blocage pour bloquer une partie du matériau de dépôt ;
dans lequel le premier axe (213 ; 313 ; 513), le second axe (214 ; 314 ; 514) et un axe de rotation du tambour de revêtement sont orientés dans une première direction ;
dans lequel le premier support de dispositif de pulvérisation cathodique (301 ; 401) et le second support de dispositif de pulvérisation cathodique (302) sont adaptés pour supporter le premier dispositif de pulvérisation cathodique rotatif (211 : 311 ; 511) et le second dispositif de pulvérisation cathodique rotatif (212 ; 312 ; 512) respectivement de manière à ce qu'au moins un composé du matériau de dépôt soit déposé sur la bande (230 ; 430 ; 530) guidée sur le tambour de revêtement (220 ; 420 ; 520), et dans lequel le premier support de dispositif de pulvérisation cathodique et le second support de dispositif de pulvérisation cathodique sont adaptés pour fournir seulement un dispositif de pulvérisation cathodique rotatif dans le premier support de dispositif de pulvérisation cathodique, et seulement un second dispositif de pulvérisation cathodique rotatif dans le second support de dispositif de pulvérisation cathodique pour une fenêtre de revêtement (250 ; 350 ; 550) ;
et dans lequel la distance (260 ; 360) entre le premier axe (213 ; 313 ; 513) et le second axe (214 ; 314 ; 514) est inférieur à environ 200 mm et dans lequel la fenêtre de revêtement (250 ; 350 ; 550) dispose d'une largeur entre environ 200 mm et environ 250 mm, la largeur de la fenêtre de revêtement étant définie par une première position (251 ; 551) et une seconde position (252; 552) de la bande (230 ; 430 ; 530) sur le tambour de revêtement (220 ; 420 ; 520) projetées sur un plan (253 ; 553) substantiellement tangent à la bande (230 ; 430 ; 530) à un point sur la bande présentant la distance la plus courte d'au moins un des dispositif de pulvérisation cathodique.

2. L'appareil de dépôt selon la revendication 1, dans lequel l'appareil de dépôt (200 ; 300) est adapté pour utiliser seulement un dispositif de pulvérisation cathodique du premier dispositif de pulvérisation cathodique rotatif (211 : 311 ; 511) et du second dispositif de pulvérisation cathodique rotatif (212 ; 312 ; 512) comme anode, et l'autre dispositif de pulvérisation cathodique respectif du premier dispositif de pulvérisation cathodique rotatif (211 : 311 ; 511) et du second dispositif de pulvérisation cathodique rotatif (212 ; 312 ; 512) comme cathode.

3. L'appareil de dépôt selon la revendication 1 ou 2, comprenant en outre un premier dispositif de pulvérisation cathodique rotatif (211 : 311 ; 511) et un second dispositif de pulvérisation cathodique rotatif (212 ; 312 ; 512).

4. L'appareil de dépôt selon la revendication 3, dans lequel un premier agencement magnétique (515) pour générer un premier champ magnétique est agencé dans le premier dispositif de pulvérisation cathodique rotatif (211 : 311 ; 511) et un second agencement magnétique (516) est agencé dans le second dispositif de pulvérisation cathodique rotatif (212 ; 312 ; 512), dans lequel le premier agencement magnétique et le second agencement magnétique sont adaptés pour augmenter le dépôt du matériau de dépôt dans la fenêtre de revêtement (250 ; 350 ; 550).

5. L'appareil de dépôt selon la revendication 4, dans lequel le dispositif de pulvérisation cathodique rotatif (211 : 311 ; 511) et le second dispositif de pulvérisation cathodique rotatif (212 ; 312 ; 512) sont agencés de sorte que le premier agencement magnétique (515) et le second agencement magnétique (516) soient agencés de façon inclinée l'un envers l'autre.

6. L'appareil de dépôt selon l'une quelconque des revendications 1 à 5, dans lequel au moins l'un du premier support de dispositif de pulvérisation cathodique (301 ; 401) et du second support de dispositif de pulvérisation cathodique (302) est adapté pour supporter un dispositif de pulvérisation cathodique présentant un diamètre extérieur entre environ 100 mm et environ 120 mm, particulièrement environ 105 mm.

7. L'appareil de dépôt selon l'une quelconque des revendications 1 à 6, dans lequel le premier support de dispositif de pulvérisation cathodique est adapté pour supporter le premier dispositif de pulvérisation cathodique rotatif (211 : 311 ; 511) et le second support de dispositif de pulvérisation cathodique est adapté pour supporter le second dispositif de pulvérisation cathodique rotatif (212 ; 312 ; 512) et dans lequel le premier dispositif de pulvérisation cathodique rotatif et le second dispositif de pulvérisation cathodique rotatif sont des dispositifs de pulvérisation cathodique jumeaux.

8. L'appareil de dépôt selon l'une quelconque des revendications 1 à 7, dans lequel la fenêtre de revêtement (250 ; 350 ; 550) dispose d'une largeur d'environ 220 mm.

9. L'appareil de dépôt selon l'une quelconque des revendications 1 à 8, dans lequel le matériau à déposer est un matériau isolant.

10. L'appareil de dépôt selon l'une quelconque des revendications 1 à 9, dans lequel le matériau à déposer est un matériau sélectionné dans le groupe d'oxyde de silicone, de nitrure de silicium, d'oxyde de titane et d'oxyde d'aluminium.

11. Procédé pour déposer un matériau de dépôt sur une bande (230 ; 430 ; 530) utilisant l'appareil de déposition selon la revendication 1, comprenant :
guider la bande sur le tambour de revêtement (220 ; 420 ; 520) devant un premier dispositif de pulvérisation cathodique rotatif (211 : 311 ; 511) présentant le premier axe de rotation et un second dispositif de pulvérisation cathodique rotatif (212 ; 312 ; 512) présentant le second axe de rotation, dans lequel le premier dispositif de pulvérisation cathodique et le second dispositif de pulvérisation cathodique sont des dispositifs de pulvérisation cathodique jumeaux rotatifs prévus pour la fenêtre de revêtement (250 ; 350 ; 550) et dans lequel le premier dispositif de pulvérisation cathodique rotatif (211 : 311 ; 511) et le second dispositif de pulvérisation cathodique rotatif (212 ; 312 ; 512) disposent au moins d'un composé du matériau de dépôt, et
recouvrir la bande (230 ; 430 ; 530) avec un matériau de dépôt dans la fenêtre de revêtement (250 ; 350 ; 550) tout en guidant la bande sur le tambour de revêtement (220 ; 420 ; 520).

12. Le procédé selon la revendication 11, dans lequel recouvrir la bande (230 ; 430 ; 530) comprend recouvrir la bande dans la fenêtre de revêtement (250 ; 350 ; 550) d'environ 220 mm.

13. Le procédé selon l'une quelconque des revendications 11 à 12, comprenant en outre utiliser au moins un parmi le premier dispositif de pulvérisation cathodique (211 : 311 ; 511) et le second dispositif de pulvérisation cathodique (211 : 311 ; 511) comme anode et l'autre dispositif de pulvérisation cathodique respectif du premier dispositif de pulvérisation cathodique et du second dispositif de pulvérisation cathodique comme cathode.

14. Le procédé selon l'une quelconque des revendications 11 à 13, comprenant en outre générer un premier champ magnétique par un premier agencement magnétique (515) dans le premier dispositif de pulvérisation cathodique (211 : 311 ; 511) et générer un second champ magnétique par un second agencement magnétique (516) dans le second dispositif de pulvérisation cathodique (212, 312, 512), dans lequel au moins un parmi le premier dispositif de pulvérisation cathodique (211 : 311 ; 511), le second dispositif de pulvérisation cathodique (212, 312, 512), le premier agencement magnétique (515) et le second agencement magnétique (516) sont agencés de sorte que le premier agencement magnétique et le second agencement magnétique soient agencés de façon inclinée l'un envers l'autre.
